# EUROPÄISCHE PATENTANMELDUNG

(11) **EP 3 561 534 A1**
(43) Veröffentlichungstag der Anmeldung: **30.10.2019**
(21) Anmeldenummer: 18169054.6
(22) Anmeldetag: 24.04.2018
(51) Int. Cl.: G01R 33/385, G01R 33/421

(54) **GRADIENTENSPULENEINHEIT FÜR EIN MAGNETRESONANZGERÄT**

(71) Anmelder: Siemens Healthcare GmbH, 91052 Erlangen (DE)
(72) Erfinder: Dietz, Peter, 90762 Fürth (DE); Fath, Sascha, 91052 Erlangen (DE); Krug, Andreas, 90762 Fürth (DE); vom Endt, Axel, 91052 Erlangen (DE)

(57) **Zusammenfassung**

Die Erfindung geht aus von einer Gradientenspuleneinheit umfassend eine Primärspule und eine Sekundärspule, wobei die Primärspule eine erste Leiterstruktur und eine zweite Leiterstruktur umfasst, die erste Leiterstruktur zu einer Erzeugung eines Magnetfeldgradienten in einem Patientenaufnahmebereich ausgebildet ist, die zweite Leiterstruktur zu einer Kompensation einer bei einer Erzeugung eines Magnetfeldgradienten entstehenden Kraft auf die Gradientenspuleneinheit ausgebildet ist, und die Sekundärspule zu einer Kompensation eines bei Erzeugung eines Magnetfeldgradienten mittels Primärspule entstehenden Streumagnetfeldes ausgebildet ist.

## Beschreibung

Die Erfindung betrifft eine Gradientenspuleneinheit umfassend eine Primärspule, eine Sekundärspule und ein Magnetresonanzgerät.

In einem Magnetresonanzgerät wird üblicherweise der zu untersuchende Körper eines Untersuchungsobjektes, insbesondere eines Patienten, in einem Patientenaufnahmebereich mit Hilfe eines Hauptmagneten einem relativ hohen Hauptmagnetfeld, beispielsweise von 1,5 oder 3 Tesla, ausgesetzt. Zusätzlich werden mit Hilfe einer Gradientenspuleneinheit Gradientenpulse ausgespielt. Über eine Hochfrequenzantenneneinheit werden dann mittels geeigneter Antenneneinrichtungen hochfrequente Hochfrequenz-Pulse (HF-Pulse), insbesondere Anregungspulse, ausgesendet, was dazu führt, dass die Kernspins bestimmter, durch diese HF-Pulse resonant angeregter Atome um einen definierten Flipwinkel gegenüber den Magnetfeldlinien des Hauptmagnetfelds verkippt werden. Bei der Relaxation der Kernspins werden Hochfrequenz-Signale, so genannte Magnetresonanz-Signale, abgestrahlt, die mittels geeigneter Hochfrequenzantennen empfangen und dann weiterverarbeitet werden. Aus den so akquirierten Rohdaten können schließlich die gewünschten Bilddaten rekonstruiert werden.

Eine Gradientenspuleneinheit umfasst typischerweise drei Primärspulen und drei dazu korrespondierende Sekundärspulen. Eine Primärspule ist typischerweise zur Erzeugung eines Magnetfeldgradienten in eine Raumrichtung ausgelegt. Eine dazu korrespondierende Sekundärspule schirmt den von der Primärspule erzeugten Magnetfeldgradienten und/oder ein von der Primärspule erzeugtes weiteres elektromagnetisches Feld derart ab, dass dieser und/oder dieses außerhalb der Gradientenspuleneinheit, insbesondere außerhalb des Patientenaufnahmebereichs, reduziert werden.

Die Primärspulen und die Sekundärspulen werden mit elektrischen Strömen gesteuert, deren Amplituden mehrere 100 A erreichen und die häufigen und raschen Wechseln der Stromrichtung mit Anstiegs- und Abfallraten von mehreren 100 kA/s unterliegen. Aufgrund der Positionierung der Gradientenspuleneinheit innerhalb des Hauptmagneten des Magnetresonanzgerätes entsteht eine große Kraft, welche auf die Gradientenspuleneinheit wirkt. Mit der Kraft ist ein Drehmoment verknüpft, welches zu einer Bewegung und/oder einer Biegung der Gradientenspuleneinheit führen kann. Dies kann im Betrieb der Gradientenspuleneinheit zu Vibrationen führen.

Bisherige Weiterentwicklungen für Gradientenspuleneinheiten betreffen hauptsächlich deren Kühlung, wie beispielsweise DE 10 2013 208 631 B3 und/oder DE 10 2011 083 204 A1.

Der Erfindung liegt die Aufgabe zugrunde, eine besonders vibrationsarme Gradientenspuleneinheit mit reduzierter elektromagnetischer Wechselwirkung außerhalb des Patientenaufnahmebereichs anzugeben. Die Aufgabe wird durch die Merkmale der unabhängigen Ansprüche gelöst. Vorteilhafte Ausgestaltungen sind in den Unteransprüchen beschrieben.

Die Erfindung betrifft eine Gradientenspuleneinheit umfassend eine Primärspule und eine Sekundärspule, wobei die Primärspule eine erste Leiterstruktur und eine zweite Leiterstruktur umfasst, die erste Leiterstruktur zu einer Erzeugung eines Magnetfeldgradienten in einem Patientenaufnahmebereich ausgebildet ist, die zweite Leiterstruktur zu einer Kompensation einer bei einer Erzeugung eines Magnetfeldgradienten entstehenden Kraft auf die Gradientenspuleneinheit ausgebildet ist, und die Sekundärspule zu einer Kompensation eines bei Erzeugung eines Magnetfeldgradienten mittels Primärspule entstehenden Streumagnetfeldes ausgebildet ist.

Eine Leiterstruktur umfasst typischerweise einen elektrischen Leiter. Die geometrische Anordnung eines elektrischen Leiters kann als Leiterstruktur bezeichnet werden. Ein Magnetfeldgradient ist typischerweise ein in eine räumliche Richtung linear ansteigendes Magnetfeld. Ein Magnetfeldgradient wird typischerweise temporär durch elektrische Ströme in der Primärspule und/oder in einer von einer Primärspule umfassten Leiterstruktur erzeugt. Die elektrischen Ströme werden typischerweise gemäß Vorgabe einer MR-Steuerungssequenz durch eine Gradientensteuereinheit in der Gradientenspuleneinheit erzeugt, insbesondere bei Ansteuerung der Gradientenspuleneinheit und/oder des Magnetresonanzgerätes.

Die erfindungsgemäße Gradientenspuleneinheit ist aufgrund der Wahl der ersten Leiterstruktur und der zweiten Leiterstruktur derart ausgebildet, dass die Kraftkompensation vorzugsweise inhärent durch die Primärspule erfolgt. Die erste Leiterstruktur ist typischerweise dazu ausgebildet, einen Magnetfeldgradienten innerhalb des Patientenaufnahmebereiches in eine erste Richtung zu erzeugen, insbesondere wenn in der ersten Leiterstruktur ein erster elektrischer Strom fließt. Im Betrieb der Gradientenspuleneinheit fließt typischerweise in der zweiten Leiterstruktur ein zweiter elektrischer Strom und/oder in einer von der Sekundärspule umfassten dritten Leiterstruktur ein dritter elektrischer Strom. Die Wechselwirkung des ersten elektrischen Stromes in der ersten Leiterstruktur und/oder des zweiten elektrischen Stromes in der zweiten Leiterstruktur und/oder des dritten elektrischen Stromes in der dritten Leiterstruktur und dem im Bereich der ersten Leiterstruktur und/oder zweiten Leiterstruktur und/oder dritten Leiterstruktur wirkenden Hauptmagnetfeld bewirkt eine Lorentzkraft, welche ein Drehmoment auf die Gradientenspuleneinheit bewirkt. Es können räumliche Bereiche der Gradientenspuleneinheit identifiziert werden, auf welche Bereiche aufgrund der Lorentzkraft ein besonders großes Drehmoment wirkt. Dort wirkende Kräfte werden vorzugsweise durch einen zweiten elektrischen Strom in der zweiten Leiterstruktur reduziert und/oder kompensiert. Der erste elektrische Strom und der der zweite elektrische Strom können voneinander verschieden sein. Der erste elektrische Strom und/oder der zweite elektrische Strom und/oder der dritte elektrische Strom können zeitlich versetzt und/oder verschieden groß sein. Der erste elektrische Strom und/oder der der zweite elektrische Strom und/oder der dritte elektrische Strom können auch gleich groß und/oder simultan sein.

Ein Streumagnetfeld ist typischerweise ein Magnetfeld, welches bei Ansteuerung der ersten Leiterstruktur und/oder der Primärspule, also bei einem Anlegen eines elektrischen Stroms in der ersten Leiterstruktur und/oder der Primärspule, außerhalb des Patientenaufnahmebereichs entsteht. Das Streumagnetfeld trägt typischerweise nicht zur Bildgebung bei, sondern kann die Bildgebung negativ beeinflussen. Das Streumagnetfeld kann mit den Gradientenspuleneinheit umgebenden Komponenten wechselwirken. Beispielsweise kann in einer der Gradientenspuleneinheit benachbarten und/oder elektrisch leitenden, Umgebung, wie beispielsweise einer das Kryostat des Hauptmagneten nach innen abschließenden Wand, einem Temperaturschild und/oder einer Hochfrequenzantenneneinheit, einen elektrischen Strom erzeugen und/oder diese erwärmen. Es wurde erkannt, dass insbesondere im radialen Außenbereich der Gradientenspuleneinheit, bevorzugt im Bereich einer das Kryostat eines Hauptmagneten nach innen abschließenden Wand und/oder eines Temperaturschildes, sich ein Streumagnetfeld und/oder durch ein Streumagnetfeld hervorgerufene Wirbelströme die Effizienz einer Kühlung des Hauptmagneten und/oder die Homogenität eines von der Gradientenspuleneinheit erzeugten Magnetfeldgradienten negativ beeinflussen können.

Die Primärspule der erfindungsgemäßen Gradientenspuleneinheit erzeugt im Betrieb typischerweise ein Streumagnetfeld, welches sich aus einem ersten Streumagnetfeld basierend auf der Generierung des Magnetfeldgradienten durch die erste Leiterstruktur, und einem zweiten Streumagnetfeld basierend auf der Kraftkompensation durch die zweite Leiterstruktur, zusammensetzt. Insbesondere die zweite Leiterstruktur kann aufgrund ihrer Ausgestaltung zur Kompensation einer bei einer Erzeugung eines Magnetfeldgradienten entstehenden Kraft ein zweites Streumagnetfeld erzeugen, welches im Vergleich zum ersten Streumagnetfeld besonders groß und/oder inhomogen und/oder ungleichmäßig ist.

Die Sekundärspule ist typischerweise derart ausgestaltet, dass ein bei Ansteuerung der Primärspule erzeugtes Streumagnetfeld reduziert, insbesondere kompensiert wird. Insbesondere eine Ausgestaltung der Gradientenspuleneinheit, gemäß welcher die Sekundärspule und die Primärspule jeweils hohlzylinderförmig ausgestaltet sind und die Sekundärspule die Primärspule radial umgibt, ermöglicht eine besonders effiziente Reduzierung des Streumagnetfeldes im Bereich des Kryostaten des Hauptmagneten, insbesondere im Bereich eines Temperaturschildes zum Hauptmagneten.

Die erfindungsgemäße Gradientenspuleneinheit ermöglicht eine besonders gute Reduzierung des Streumagnetfeldes, da die Sekundärspule von der ersten Leiterstruktur und der zweiten Leiterstruktur entstehende Streumagnetfelder kompensieren kann. Die Sekundärspule ist vorzugsweise nicht dazu ausgebildet, eine im Betrieb der Gradientenspuleneinheit entstehende Kraft und/oder ein entstehendes Drehmoment zu kompensieren. Dies ermöglicht eine voneinander unabhängige Kompensation einer Kraft und eines Streumagnetfeldes. Dadurch ist die erfindungsgemäße Gradientenspuleneinheit besonders vibrationsarm und weist eine reduzierte elektromagnetische Wechselwirkung mit elektrischen Komponenten eines Magnetresonanzgerätes und/oder Personen außerhalb des Patientenaufnahmebereichs auf.

Die erfindungsgemäße Gradientenspuleneinheit kann dermaßen ausgestaltet sein, dass die erste Leiterstruktur dazu ausgebildet ist, im Patientenaufnahmebereich einen möglichst homogenen Magnetfeldgradienten zu erzeugen. Ein Magnetfeldgradient wird typischerweise als homogen bezeichnet, wenn der Magnetfeldgradient in eine Raumrichtung linear ansteigt. Ein Magnetfeldgradient wird typischerweise als homogen bezeichnet, wenn dessen Gradient, insbesondere dessen räumliche Ableitung, konstant, insbesondere räumlich konstant, ist. Die Bestimmung der ersten Leiterstruktur kann gemäß einer Optimierung erfolgen, wobei beispielsweise eine Homogenität eines Magnetfeldgradienten in verschiedenen Teilbereichen des Patientenaufnahmebereiches verschieden gewichtet wird.

Basierend auf einer derart gewählten ersten Leiterstruktur können die zweite Leiterstruktur und die Sekundärspule bestimmt werden. Diese Bestimmung kann gemäß einem Optimierungsverfahren erfolgen, wobei einerseits bei Ansteuerung der ersten Leiterstruktur und/oder bei Ansteuerung der zweiten Leiterstruktur und/oder bei Ansteuerung der Sekundärspule entstehende Kräfte sich vorzugsweise zumindest teilweise gegenseitig aufheben und somit deren Summe, insbesondere die gesamte auf die Gradientenspuleneinheit wirkende Kraft, reduziert und/oder minimiert wird. Andererseits berücksichtigt das Optimierungsverfahren vorzugsweise durch ein Streumagnetfeld hervorgerufene Wirbelströme und/oder eine Homogenität des Streumagnetfeldes und/oder von dem Streumagnetfeld erfasste Bauteile des Magnetresonanzgerätes derart, dass die Sekundärspule und/oder die zweite Leiterstruktur und die Sekundärspule gemeinsam zu einer Kompensation des Streumagnetfeldes beitragen können. Die Stärke der Reduzierung des Streumagnetfeldes und die Stärke der Reduzierung der Kraft kann dabei im Optimierungsverfahren unterschiedlich stark gewichtet werden. Dadurch kann das Streumagnetfeld, insbesondere im Bereich des Kryostaten des Hauptmagneten, bevorzugt im Bereich eines Temperaturschildes zum Hauptmagneten minimiert und/oder eliminiert werden. Dadurch wird eine Erwärmung des Kryostaten des Hauptmagneten reduziert, wodurch ein geringerer Energieeintrag erfolgt und/oder weniger Kühlmittel erforderlich ist. Dies ist insbesondere vorteilhaft bei Anordnungen der Gradientenspuleneinheit mit besonders geringem Abstand zum Temperaturschild des Hauptmagneten und/oder bei supraleitenden Hauptmagneten mit Supraleitern ohne Immersion in supraleitendes Medium.

Eine Ausführungsform der Gradientenspuleneinheit sieht vor, dass die erste Leiterstruktur und die zweite Leiterstruktur jeweils zumindest teilweise spiralförmig ausgebildet sind. Die zweite Leiterstruktur ist vorzugsweise eine Gegenwindung zur ersten Leiterstruktur. Die zweite Leiterstruktur ist vorzugsweise zumindest teilweise neben der ersten Leiterstruktur angeordnet. Die erste Leiterstruktur und die zweite Leiterstruktur sind vorzugsweise sattelförmig ausgestaltet, wobei sie einen gleichen Krümmungsradius aufweisen. Die erste Leiterstruktur und die zweite Leiterstruktur sind vorzugsweise derart ausgestaltet, dass sie auf einer Oberfläche eines Zylinders angeordnet werden können. Die erste Leiterstruktur kann auch zumindest teilweise schneckenförmig und/oder ringförmig und/oder kreisförmig ausgebildet sein. Die zweite Leiterstruktur kann auch zumindest teilweise schneckenförmig und/oder ringförmig und/oder kreisförmig ausgebildet sein. Die erste Leiterstruktur und die zweite Leiterstruktur sind vorzugsweise frei von einer räumlichen Überlappung. Insbesondere bei Projektion der ersten Leiterstruktur und der zweiten Leiterstruktur auf zumindest eine die Längsachse des gemäß einer Ausführungsform von der Gradientenspuleneinheit gebildeten Hohlzylinders umfassende Ebene sind die erste Leiterstruktur und die zweite Leiterstruktur vorzugsweise frei von einer räumlichen Überlappung. Die Längsachse ist typischerweise in axialer Richtung ausgerichtet. Eine derartige Ausgestaltung der ersten Leiterstruktur und der zweiten Leiterstruktur ermöglicht sowohl die Erzeugung eines besonders homogenen Magnetfeldgradienten, als auch eine im Betrieb vibrationsarme Gradientenspuleneinheit. Die erste Leiterstruktur und die zweite Leiterstruktur, insbesondere die Primärspule, sind vorzugsweise zusätzlich sattelförmig ausgestaltet. Die dritte Leiterstruktur, insbesondere die Sekundärspule, ist vorzugsweise zusätzlich sattelförmig ausgestaltet.

Eine Ausführungsform der Gradientenspuleneinheit sieht vor, dass die erste Leiterstruktur einen ersten Mittelpunkt und die zweite Leiterstruktur einen zweiten Mittelpunkt umschließen und der erste Mittelpunkt vom zweiten Mittelpunkt verschieden ist. Die erste Leiterstruktur umgibt demnach vorzugsweise spiralförmig und/oder schneckenförmig und/oder ringförmig und/oder kreisförmig den ersten Mittelpunkt. Die zweite Leiterstruktur umgibt demnach vorzugsweise spiralförmig und/oder schneckenförmig und/oder ringförmig und/oder kreisförmig den zweiten Mittelpunkt. Der erste Mittelpunkt und der zweite Mittelpunkt sind vorzugsweise voneinander verschieden. Insbesondere kann der zweite Mittelpunkt einen größeren Abstand von der geometrischen Mitte der Gradientenspuleneinheit aufweisen als der erste Mittelpunkt. Diese Ausführungsform der ersten Leiterstruktur und der zweiten Leiterstruktur ermöglicht sowohl die Erzeugung eines besonders homogenen Magnetfeldgradienten, als auch eine im Betrieb vibrationsarme Gradientenspuleneinheit.

Eine Ausführungsform der Gradientenspuleneinheit sieht vor, dass die erste Leiterstruktur und die zweite Leiterstruktur elektrisch miteinander verbunden sind. Gemäß dieser Ausführungsform können die erste Leiterstruktur und die zweite Leiterstruktur gleichzeitig durch Anlegen eines elektrischen Stromes betrieben werden. Dies ist besonders vorteilhaft, da die Ansteuerung und/oder die elektrische Versorgung der Primärspule vereinfacht werden. Ebenso kann somit eine synchrone Ansteuerung der erste Leiterstruktur und die zweite Leiterstruktur ermöglicht werden.

Eine Ausführungsform der Gradientenspuleneinheit sieht vor, dass die Sekundärspule eine dritte Leiterstruktur umfasst, welche zu einer Kompensation eines bei Erzeugung eines Magnetfeldgradienten mittels erster Leiterstruktur und zweiter Leiterstruktur entstehenden Streumagnetfeldes ausgebildet ist. Die erste Leiterstruktur, die zweite Leiterstruktur und die dritte Leiterstruktur sind vorzugsweise elektrisch miteinander verbunden. Insbesondere bei einer näherungsweise benachbarten, vorzugsweise flächig benachbarten, Positionierung der dritten Leiterstruktur und/oder der Sekundärspule zur Primärspule kann das Streumagnetfeld der Primärspule besonders gut kompensiert werden. Die dritte Leiterstruktur ist vorzugsweise auf der von der Primärspule abgewandten Seite vom Patientenaufnahmebereich angeordnet. Eine derartig ausgestaltete Sekundärspule ermöglicht eine besonders gute Abschirmung eines von der Primärspule erzeugten Streumagnetfeldes.

Eine Ausführungsform der Gradientenspuleneinheit sieht vor, dass die dritte Leiterstruktur spiralförmig ausgebildet ist. Die dritte Leiterstruktur kann auch zumindest teilweise schneckenförmig und/oder ringförmig und/oder kreisförmig ausgebildet sein. Dadurch kann die dritte Leiterstruktur dazu ausgebildet sein, ein besonders homogenes elektromagnetisches Feld, insbesondere Magnetfeld, zu erzeugen, welches sowohl das von der Primärspule erzeugte Streumagnetfeld kompensiert, als auch inhärent homogen und/oder kontinuierlich ist.

Eine Ausführungsform der Gradientenspuleneinheit sieht vor, dass die dritte Leiterstruktur dellenfrei ist. Eine Leiterstruktur ist typischerweise dellenfrei, wenn der zweite Gradient des geometrischen Verlaufes der Leiterstruktur positiv oder negativ ist. Die dritte Leiterstruktur weist vorzugsweise eine stetige Krümmung und/oder einen stetigen Gradienten auf. Dies resultiert in einer geringen elektromagnetischen Wechselwirkung mit den die Gradientenspuleneinheit umgebenden Bauteilen eines Magnetresonanzgerätes.

Eine Ausführungsform der Gradientenspuleneinheit sieht vor, dass die dritte Leiterstruktur symmetrisch ist. Die dritte Leiterstruktur ist vorzugsweise als gleichförmige und leicht rechteckig verzerrte Spirale ausgebildet, welche einen dritten Mittelpunkt umschließt. Die dritte Leiterstruktur ist demnach näherungsweise punktsymmetrisch zum dritten Mittelpunkt. Dies resultiert in einer gleichmäßigen räumlichen Verteilung des von der dritten Leiterstruktur umfassten elektrischen Leiters. Dies resultiert in einer besonders guten Abschirmung des Streumagnetfeldes und einer geringen elektromagnetischen Wechselwirkung mit den die Gradientenspuleneinheit umgebenden Bauteilen eines Magnetresonanzgerätes.

Eine Ausführungsform der Gradientenspuleneinheit sieht vor, dass die dritte Leiterstruktur dazu ausgebildet ist, eine gleichmäßige Stromdichte zu erzeugen. Die dritte Leiterstruktur weist hierfür vorzugsweise einen geringen und/oder gleichmäßigen Abstand zwischen benachbarten Leitern auf. Dies resultiert in einem homogenen und/oder kontinuierlichen Magnetfeld zur Kompensation des Streumagnetfeldes. Vorzugsweise ist die dritte Leiterstruktur dazu ausgebildet, an der auf der von der Primärspule abgewandten Seite vom Patientenaufnahmebereich ein Magnetfeld zu erzeugen, welches ein von der Primärspule erzeugtes Streumagnetfeld reduziert. Dadurch kann die dritte Leiterstruktur dazu ausgebildet sein, ein besonders homogenes elektromagnetisches Feld, insbesondere Magnetfeld, zu erzeugen, welches sowohl das von der Primärspule erzeugte Streumagnetfeld kompensiert, als auch inhärent homogen und/oder kontinuierlich ist. Dies ist insbesondere in Hinblick auf eine von der dritten Leiterstruktur und/oder von der Sekundärspule ausgehende elektromagnetische Wechselwirkung mit deren Umgebung vorteilhaft. So erzeugt eine derartig ausgebildete dritte Leiterstruktur und/oder eine Gradientenspuleneinheit gemäß dieser Ausführungsform typischerweise geringe elektrische Ströme in einem der Sekundärspule benachbarten Kryostat des Hauptmagneten und/oder Temperaturschild. Insbesondere können gemäß dieser Ausführungsform Wirbelströme in diesen Bereichen reduziert werden.

Eine Ausführungsform der Gradientenspuleneinheit sieht vor, dass die erste Leiterstruktur, die zweite Leiterstruktur und die dritte Leiterstruktur innerhalb eines Quadranten der Gradientenspuleneinheit angeordnet sind.

Eine Ausführungsform der Gradientenspuleneinheit sieht vor, dass die Gradientenspuleneinheit vier zueinander symmetrische Quadranten aufweist. Die Gradientenspuleneinheit umfasst typischerweise vier zueinander punktsymmetrische Quadranten, wobei innerhalb jedes Quadranten eine erste Leiterstruktur, eine zweite Leiterstruktur und eine dritte Leiterstruktur angeordnet sind. Die Leiterstrukturen der vier Quadranten sind vorzugsweise gemeinsam dazu ausgebildet in einem von der Gradientenspuleneinheit umschlossenen Patientenaufnahmebereich ein homogenen Magnetfeldgradienten zu erzeugen und/oder im radialen Außenbereich der Gradientenspuleneinheit im Betrieb aktiv geschirmt zu sein und/oder im Betrieb der Gradientenspuleneinheit entstehende Kräfte zu kompensieren.

Die Gradientenspuleneinheit kann auch asymmetrisch ausgebildet sein. Insbesondere die erste Leiterstruktur und/oder die dritte Leiterstruktur können asymmetrisch ausgebildet sein. Ebenso kann die erste Leiterstruktur und/oder die zweite Leiterstruktur und/oder eine weitere von der Primärspule umfasste Leiterstruktur zur Modenkompensation zur Vibrations- und/oder Lärmminimierung ausgebildet sein.

Eine Ausführungsform der Gradientenspuleneinheit sieht vor, dass die Gradientenspuleneinheit hohlzylinderförmig ausgebildet ist und die zweite Leiterstruktur zwischen einem Längsende der Gradientenspuleneinheit und der ersten Leiterstruktur angeordnet ist.

Es wurde erkannt, dass aufgrund der Lorentzkraft insbesondere an den Längsenden der Gradientenspuleneinheit eine besonders große Kraft auf die Gradientenspuleneinheit wirkt. Eine Anordnung der zweiten Leiterstruktur zu einer Kompensation einer bei einer Erzeugung eines Magnetfeldgradienten entstehenden Kraft auf die Gradientenspuleneinheit gemäß dieser Ausführungsform ist demnach besonders effizient. Dadurch können Vibrationen der Gradientenspuleneinheit besonders gut reduziert werden. Zudem weist der hier beschriebene bevorzugte räumliche Bereich für die zweite Leiterstruktur vom Mittelpunkt der Gradientenspuleneinheit, insbesondere vom Mittelpunkt des Patientenaufnahmebereiches, einen besonders großen Abstand auf. Dadurch wird die Homogenität eines von der ersten Leiterstruktur erzeugten Magnetfeldgradienten im Zentrum des Patientenaufnahmebereiches möglichst gering beeinflusst. Dies resultiert in einer besonders guten Qualität der aufzunehmenden Bilddaten.

Eine Ausführungsform der Gradientenspuleneinheit sieht vor, dass die Sekundärspule einen größeren Radius aufweist als die Primärspule. Die Primärspule ist vorzugsweise derart ausgestaltet, dass sie auf einer Oberfläche eines Zylinders mit einem ersten Radius angeordnet werden kann. Die Sekundärspule ist vorzugsweise derart ausgestaltet, dass sie auf einer Oberfläche eines Zylinders mit einem zweiten Radius angeordnet werden kann. Der zweite Radius ist gemäß dieser Ausführungsform größer als der erste Radius. Vorzugsweise sind die Primärspule und die Sekundärspule jeweils hohlzylinderförmig ausgebildet. Die Primärspule ist vorzugsweise innerhalb des Hohlbereiches der Sekundärspule angeordnet. Die Primärspule und die Sekundärspule sind vorzugsweise konzentrisch angeordnet. Zwischen der Primärspule und der Sekundärspule ist typischerweise zumindest eine Kühlvorrichtung angeordnet, welche die Primärspule von der Sekundärspule beabstandet.

Typischerweise ist der Abstand zwischen der Primärspule und der Sekundärspule größer als der Abstand zwischen der Sekundärspule und einer das Kryostat des Magnetresonanzgerätes nach innen abschließenden Wand und/oder eines Temperaturschildes. Insbesondere die zweite Leiterstruktur kann aufgrund ihrer Ausgestaltung zur Kompensation einer bei einer Erzeugung eines Magnetfeldgradienten entstehenden Kraft ein zweites Streumagnetfeld erzeugen, welches im Vergleich zum ersten Streumagnetfeld besonders groß und/oder inhomogen und/oder ungleichmäßig ist. Wird die zweite Leiterstruktur von der Primärspule umfasst, so ist aufgrund des räumlichen Abstandes zwischen der Primärspule und der Sekundärspule das Streumagnetfeld, insbesondere auch das zweite Streumagnetfeld, im Bereich der Sekundärspule, insbesondere in einem radial außerhalb der Sekundärspule gelegenen Bereich, bereits gleichmäßig und/oder homogen und/oder glatt. Dadurch ist das Streumagnetfeld, insbesondere auch das zweite Streumagnetfeld, im Bereich einer das Kryostat des Magnetresonanzgerätes nach innen abschließenden Wand und/oder eines Temperaturschildes gleichmäßig und/oder homogen und kann besonders gut durch die Sekundärspule kompensiert werden. Die dritte Leiterstruktur kann somit gleichmäßig innerhalb der Sekundärspule ausgestaltet sein und/oder eine gleichmäßige Stromdichte erzeugen und dennoch das Streumagnetfeld besonders gut kompensieren. Gleichzeitig können Wirbelströme vermieden werden.

Des Weiteren geht die Erfindung aus von einem Magnetresonanzgerät umfassend eine erfindungsgemäße Gradientenspuleneinheit, eine Gradientensteuereinheit und einen Hauptmagneten. Der Hauptmagnet ist typischerweise als supraleitender Magnet ausgebildet, wobei die das Hauptmagnetfeld erzeugenden supraleitenden Leiter innerhalb eines Kryostaten angeordnet sind. Die Gradientenspuleneinheit ist typischerweise in einem zylinderförmigen Hohlbereich des Kryostat benachbart zu einer das Kryostat nach innen abschließenden Wand, vorzugsweise umfassend ein Temperaturschild, angeordnet.

Die Gradientenspuleneinheit umfasst typischerweise drei Primärspulen und drei Sekundärspulen, wobei zumindest eine, bevorzugt zumindest zwei, der drei Primärspulen entsprechend einer der von einer vorangehend beschriebenen Ausführungsform einer Gradientenspuleneinheit umfassten Primärspule ausgestaltet ist. Ebenso ist zumindest eine, bevorzugt zumindest zwei, der drei Sekundärspulen entsprechend einer der von einer vorangehend beschriebenen Ausführungsform einer Gradientenspuleneinheit umfassten Sekundärspule ausgestaltet.

Die erfindungsgemäße Gradientenspuleneinheit kann in das Magnetresonanzgerät integriert sein. Die erfindungsgemäße Gradientenspuleneinheit kann auch separat von dem Magnetresonanzgerät installiert sein. Die erfindungsgemäße Gradientenspuleneinheit kann mit dem Magnetresonanzgerät verbunden sein. Ausführungsformen des erfindungsgemäßen Magnetresonanzgerätes sind analog zu den Ausführungsformen der erfindungsgemäßen Gradientenspuleneinheit ausgebildet. Das Magnetresonanzgerät kann weitere Steuerungskomponenten aufweisen, welche nötig und/oder vorteilhaft sind. Auch kann das Magnetresonanzgerät dazu ausgebildet sein, Steuerungssignale zu senden und/oder Steuerungssignale zu empfangen und/oder zu verarbeiten. Die Vorteile des erfindungsgemäßen Magnetresonanzgerätes entsprechen im Wesentlichen den Vorteilen der erfindungsgemäßen Gradientenspuleneinheit, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt.

Weitere Vorteile, Merkmale und Einzelheiten der Erfindung ergeben sich aus den im Folgenden beschriebenen Ausführungsbeispielen sowie anhand der Zeichnungen.
Es zeigen:
- Fig. 1: eine schematische Darstellung eines erfindungsgemäßen Magnetresonanzgerätes,
- Fig. 2: eine schematische Darstellung einer Gradientenspuleneinheit zur Erläuterung von Parametern,
- Fig. 3: eine schematische Darstellung einer ersten Ausführungsform einer erfindungsgemäßen Gradientenspuleneinheit,
- Fig. 4: eine schematische Darstellung einer ersten Ausführungsform einer ersten Leiterstruktur und einer zweiten Leiterstruktur einer Primärspule,
- Fig. 5: eine schematische Darstellung einer ersten Ausführungsform einer dritten Leiterstruktur einer Sekundärspule.

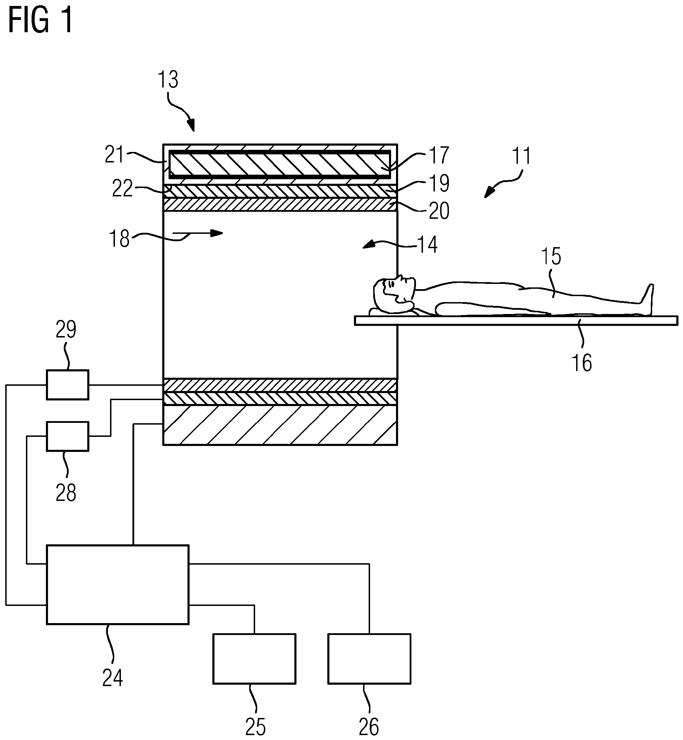

Figur 1 zeigt ein erfindungsgemäßes Magnetresonanzgerät 11 in einer schematischen Darstellung. Das Magnetresonanzgerät 11 umfasst eine von einer Magneteinheit 13 gebildeten Detektoreinheit mit einem Hauptmagneten 17 zu einem Erzeugen eines starken und insbesondere konstanten Hauptmagnetfelds 18.

Der Hauptmagnet 17 ist typischerweise als supraleitender Magnet ausgebildet, wobei die das Hauptmagnetfeld erzeugenden supraleitenden Leiter innerhalb eines Kryostaten 21 angeordnet sind. Das Kryostat 21 weist einen zylinderförmigen Hohlbereich auf, an dessen nach innen abschließenden Wand ein Temperaturschild 22 angeordnet ist. Zudem weist das Magnetresonanzgerät 11 einen zylinderförmigen Patientenaufnahmebereich 14 zu einer Aufnahme eines Patienten 15 auf, wobei der Patientenaufnahmebereich 14 in einer Umfangsrichtung von der Magneteinheit 13 zylinderförmig umschlossen ist. Der Patient 15 kann mittels einer Patientenlagerungsvorrichtung 16 des Magnetresonanzgeräts 11 in den Patientenaufnahmebereich 14 geschoben werden. Die Patientenlagerungsvorrichtung 16 weist hierzu einen Patiententisch auf, der bewegbar innerhalb des Magnetresonanzgeräts 11 angeordnet ist.

Die Magneteinheit 13 weist weiterhin eine erfindungsgemäße Gradientenspuleneinheit 19 auf, die für eine Ortskodierung während einer Bildgebung verwendet werden. Die Gradientenspuleneinheit 19 kann auch außerhalb der Magneteinheit 13 angeordnet sein. Die Gradientenspuleneinheit 19 wird mittels einer Gradientensteuereinheit 28 angesteuert. Des Weiteren weist die Magneteinheit 13 eine Hochfrequenzantenneneinheit 20, welche im gezeigten Fall als fest in das Magnetresonanzgerät 11 integrierte Körperspule ausgebildet ist, und eine Hochfrequenzantennensteuereinheit 29 zu einer Anregung einer Polarisation, die sich in dem von dem Hauptmagneten 17 erzeugten Hauptmagnetfeld 18 einstellt, auf. Die Hochfrequenzantenneneinheit 20 wird von der Hochfrequenzantennensteuereinheit 29 angesteuert und strahlt hochfrequente Hochfrequenz-Pulse in einen Untersuchungsraum, der im Wesentlichen von dem Patientenaufnahmebereich 14 gebildet ist, ein.

Zu einer Steuerung des Hauptmagneten 17, der Gradientensteuereinheit 28 und der Hochfrequenzantennensteuereinheit 29 weist das Magnetresonanzgerät 11 eine Steuerungseinheit 24 auf. Die Steuerungseinheit 24 steuert zentral das Magnetresonanzgerät 11, wie beispielsweise das Durchführen von MR-Steuerungssequenzen. Zudem umfasst die Steuerungseinheit 24 eine nicht näher dargestellte Rekonstruktionseinheit zu einer Rekonstruktion von medizinischen Bilddaten, die während der Magnetresonanzuntersuchung erfasst werden. Das Magnetresonanzgerät 11 weist eine Anzeigeeinheit 25 auf. Steuerinformationen wie beispielsweise Steuerungsparameter, sowie rekonstruierte Bilddaten können auf der Anzeigeeinheit 25, beispielsweise auf zumindest einem Monitor, für einen Benutzer angezeigt werden. Zudem weist das Magnetresonanzgerät 11 eine Eingabeeinheit 26 auf, mittels derer Informationen und/oder Steuerungsparameter während eines Messvorgangs von einem Benutzer eingegeben werden können. Die Steuerungseinheit 24 kann die Gradientensteuereinheit 28 und/oder Hochfrequenzantennensteuereinheit 29 und/oder die Anzeigeeinheit 25 und/oder die Eingabeeinheit 26 umfassen.

Das dargestellte Magnetresonanzgerät 11 kann selbstverständlich weitere Komponenten umfassen, die Magnetresonanzgeräte 11 gewöhnlich aufweisen. Eine allgemeine Funktionsweise eines Magnetresonanzgeräts 11 ist zudem dem Fachmann bekannt, so dass auf eine detaillierte Beschreibung der weiteren Komponenten verzichtet wird.

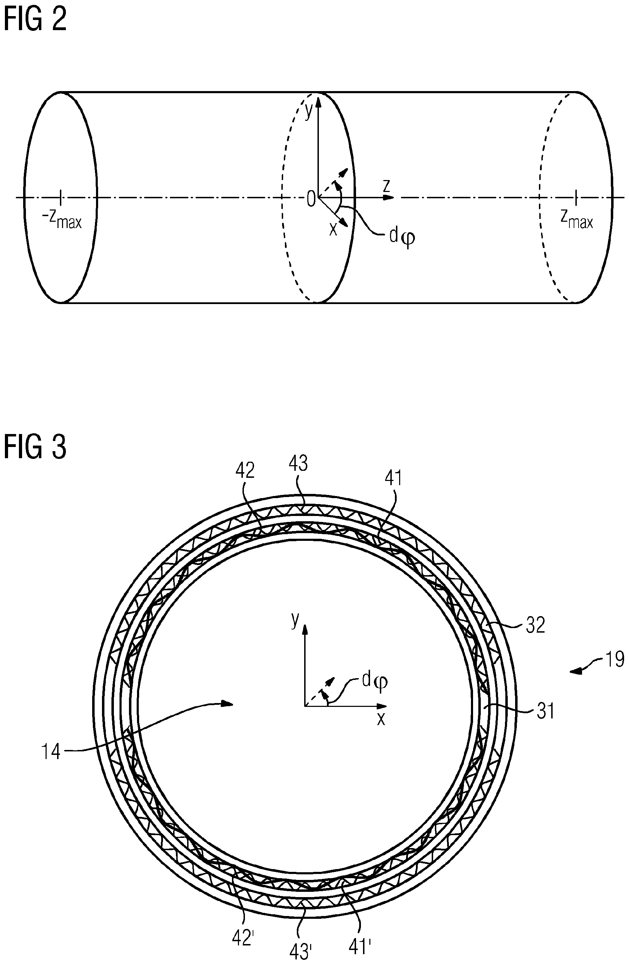

Figur 2 zeigt eine schematische Darstellung einer Gradientenspuleneinheit 19 zur Erläuterung von Parametern. Die Gradientenspuleneinheit 19 ist zylinderförmig ausgebildet und kann in vier Quadranten untergliedert werden. Die erste Leiterstruktur 41, die zweite Leiterstruktur 42 und die dritte Leiterstruktur 43 sind typischerweise innerhalb eines Quadranten, insbesondere innerhalb des gleichen Quadranten, der Gradientenspuleneinheit 19 angeordnet. Die Gradientenspuleneinheit 19 weist typischerweise in jedem Quadranten eine erste Leiterstruktur 41, eine zweite Leiterstruktur 42 und eine dritte Leiterstruktur 43 auf, wobei die Leiterstrukturen 41, 42, 43 in den Quadranten vorzugsweise symmetrisch, insbesondere punktsymmetrisch zum Ursprung der Gradientenspuleneinheit 19 sind. Ein Quadrant wird entlang der z-Achse durch den Ursprung der Gradientenspuleneinheit 19 und durch ein Längsende der Gradientenspuleneinheit 19 bei +zₘₐₓ oder -_{Zmax} begrenzt. Ein Quadrant der Gradientenspuleneinheit 19 wird in eine erste Richtung durch die maximale Ausdehnung der Gradientenspuleneinheit 19 in die erste Richtung bestimmt. Ein Quadrant der Gradientenspuleneinheit 19 wird in eine zweite Richtung durch den Abstand einer Außenseite der Gradientenspuleneinheit 19 entlang der zweiten Richtung vom Ursprung bestimmt. Die erste Richtung und die zweite Richtung sind typischerweise senkrecht zueinander. Ist die erste Leiterstruktur 41 dazu ausgebildet, einen Magnetfeldgradienten in x-Richtung zu erzeugen, so entspricht die erste Richtung der x-Richtung. Ist die erste Leiterstruktur 41 dazu ausgebildet, einen Magnetfeldgradienten in y-Richtung zu erzeugen, so entspricht die erste Richtung der y-Richtung.

Eine Gradientenspuleneinheit 19 weist vorzugsweise zumindest zwei Primärspulen auf, welche erfindungsgemäß ausgebildet sind. So umfasst die Gradientenspuleneinheit 19 vorzugsweise eine Primärspule 31 mit einer ersten Leiterstruktur 41 und einer zweiten Leiterstruktur 42. Die Gradientenspuleneinheit 19 umfasst vorzugsweise eine weitere Primärspule mit einer weiteren ersten Leiterstruktur und einer weiteren zweiten Leiterstruktur. Die Primärspule 41 und die weitere Primärspule unterscheiden sich typischerweise dadurch, dass die Primärspule 41 dazu ausgebildet ist, einen Magnetfeldgradienten in x-Richtung zu erzeugen, und die weitere Primärspule dazu ausgebildet ist, einen Magnetfeldgradienten in y-Richtung zu erzeugen. Die Primärspule 41 und die weitere Primärspule unterscheiden sich dabei um einen Winkel dϕ von 90°. Ebenso umfasst eine derartige Gradientenspuleneinheit 19 vorzugsweise eine Sekundärspule 32 zu einer Kompensation eines bei Erzeugung eines Magnetfeldgradienten mittels Primärspule 31 entstehenden Streumagnetfeldes und eine weitere Sekundärspule zu einer Kompensation eines bei Erzeugung eines Magnetfeldgradienten mittels der weiteren Primärspule entstehenden Streumagnetfeldes auf. Die Gradientenspuleneinheit 19 umfasst vorzugsweise eine zusätzliche Primärspule, welche dazu ausgebildet ist, einen Magnetfeldgradienten in z-Richtung zu erzeugen, und eine zusätzliche Sekundärspule zu einer Kompensation eines bei Erzeugung eines Magnetfeldgradienten mittels zusätzlicher Primärspule entstehenden Streumagnetfeldes. Die Primärspule, die weitere Primärspule, die zusätzliche Primärspule, die Sekundärspule, die weitere Sekundärspule und die zusätzliche Sekundärspule sind typischerweise zumindest teilweise konzentrisch und/oder ineinander verschachtelt angeordnet.

Figur 3 zeigt eine schematische Darstellung einer ersten Ausführungsform einer erfindungsgemäßen Gradientenspuleneinheit 19. Die Gradientenspuleneinheit 19 umfasst eine Primärspule 31 und eine Sekundärspule 32. Die Primärspule 31 umfasst eine erste Leiterstruktur 41, 41' und eine zweite Leiterstruktur 42, 42'. Die Gradientenspuleneinheit 19, insbesondere die Primärspule 31, umfasst die erste Leiterstruktur 41, 41' vorzugsweise zweimal. Die beiden ersten Leiterstrukturen 41, 41' sind dabei vorzugsweise punktsymmetrisch zum Mittelpunkt des Patientenaufnahmebereichs 14 angeordnet. Die Gradientenspuleneinheit 19, insbesondere die Primärspule 31, umfasst die zweite Leiterstruktur 42, 42' vorzugsweise zweimal. Die beiden zweiten Leiterstrukturen 42, 42' sind dabei vorzugsweise punktsymmetrisch zum Mittelpunkt des Patientenaufnahmebereichs 14 angeordnet. Die zweite Leiterstruktur 42, 42' liegt vorzugsweise entlang der Längsachse der Gradientenspuleneinheit 19, insbesondere senkrecht zum Bild, vor und/oder hinter der ersten Leiterstruktur 41, 41. Die erste Leiterstruktur 41, 41' und/oder die beiden ersten Leiterstrukturen 41, 41' gemeinsam sind zu einer Erzeugung eines Magnetfeldgradienten in einem Patientenaufnahmebereich 14 ausgebildet. Im dargestellten Fall ist die erste Leiterstruktur 41, 41' zu einer Erzeugung eines Magnetfeldgradienten in x-Richtung ausgebildet. Die zweite Leiterstruktur 42, 42' ist zu einer Kompensation einer bei einer Erzeugung eines Magnetfeldgradienten entstehenden Kraft auf die Gradientenspuleneinheit 19 ausgebildet.

Die Sekundärspule 32 umfasst vorzugsweise eine dritte Leiterstruktur 43, 43'. Die Gradientenspuleneinheit 19, insbesondere die Sekundärspule 32, umfasst die dritte Leiterstruktur 43, 43' vorzugsweise zweimal. Die beiden dritten Leiterstrukturen 43, 43' sind dabei vorzugsweise punktsymmetrisch zum Mittelpunkt des Patientenaufnahmebereichs 14 angeordnet. Die Sekundärspule 32, insbesondere die dritte Leiterstruktur 43, 43', ist zu einer Kompensation eines bei Erzeugung eines Magnetfeldgradienten mittels Primärspule 31 entstehenden Streumagnetfeldes ausgebildet ist. Die Sekundärspule 32 weist vorzugsweise einen größeren Radius, insbesondere bezüglich des Mittelpunktes des Patientenaufnahmebereichs 14, auf, als die Primärspule 31.

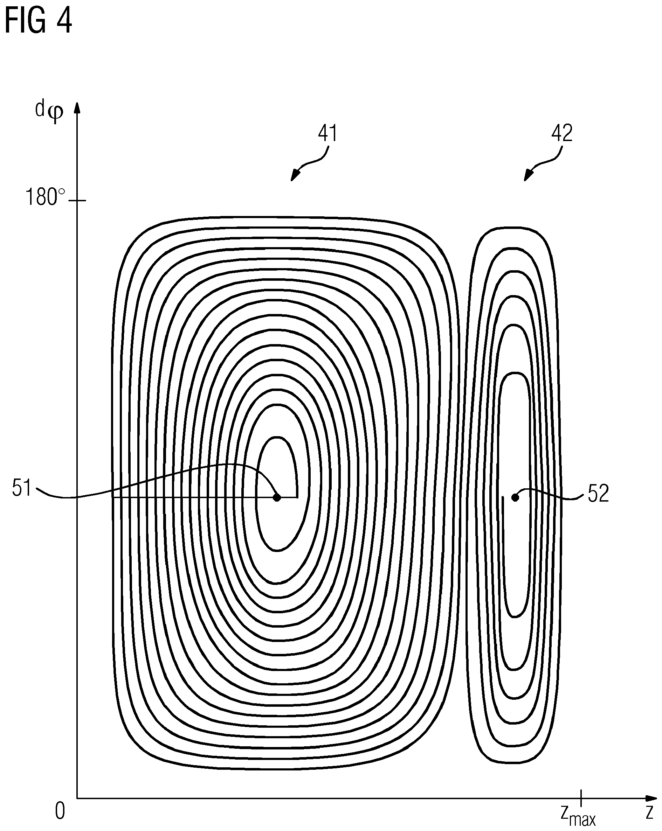

Figur 4 zeigt eine schematische Darstellung einer ersten Ausführungsform einer ersten Leiterstruktur 41 und einer zweiten Leiterstruktur 42 einer Primärspule 31. Die erste Leiterstruktur 41 und die zweite Leiterstruktur 42 sind dabei planar, insbesondere abgerollt, dargestellt. Die Ordinate beschreibt dϕ. Innerhalb der Gradientenspule 19 sind die erste Leiterstruktur 41 und die zweite Leiterstruktur 42 vorzugsweise sattelförmig ausgestaltet. Die erste Leiterstruktur 41 und die zweite Leiterstruktur 42 weisen in der Sattelform vorzugsweise einen gleichen Radius auf. In planarer Darstellung sind die erste Leiterstruktur 41 und die zweite Leiterstruktur 42 vorzugsweise frei von einer räumlichen Überlappung.

Die erste Leiterstruktur 41 und die zweite Leiterstruktur 42 sind jeweils zumindest teilweise spiralförmig ausgebildet. So umschließt die erste Leiterstruktur 41 einen ersten Mittelpunkt 51 in der dargestellten Ausführungsform spiralförmig. Die zweite Leiterstruktur 42 umschließt einen zweiten Mittelpunkt 52 in der dargestellten Ausführungsform spiralförmig. Ebenso sind die erste Leiterstruktur 41 und die zweite Leiterstruktur 42 elektrisch miteinander verbunden. Insbesondere schließt sich die spiralförmige zweite Leiterstruktur 42 der spiralförmigen ersten Leiterstruktur 41 an und/oder die erste Leiterstruktur 41 und die zweite Leiterstruktur 42 kann durch einen einzigen elektrischen Leiter realisiert werden.

Die zweite Leiterstruktur 42 ist vorzugsweise zwischen einem Längsende der Gradientenspuleneinheit 19 und der ersten Leiterstruktur angeordnet. Die zweite Leiterstruktur 42 schließt demnach die Gradientenspuleneinheit 19 vorzugsweise zum Längsende ab. Die erste Leiterstruktur 41 ist entlang der Längsachse vorzugsweise zwischen dem Mittelpunkt der Gradientenspuleneinheit 19 bei z=0 und der zweiten Leiterstruktur 42 angeordnet. Die Gradientenspuleneinheit 19 weist zwei Längsenden bei +zₘₐₓ und -zₘₐₓ auf.

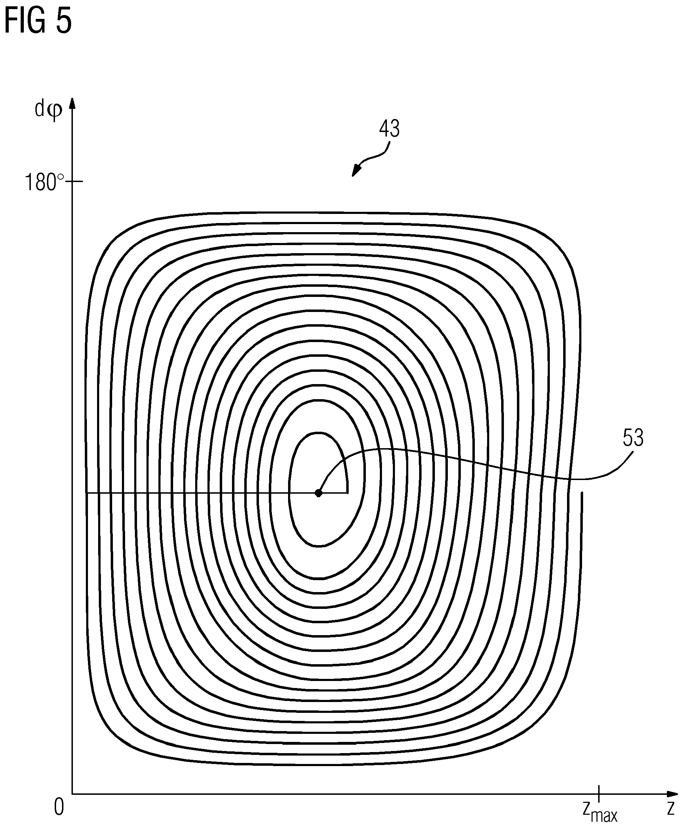

Figur 5 zeigt eine schematische Darstellung einer ersten Ausführungsform einer dritten Leiterstruktur 43 einer Sekundärspule 32. Die dritte Leiterstruktur 43 ist zu einer Kompensation eines bei Erzeugung eines Magnetfeldgradienten mittels erster Leiterstruktur 41 und zweiter Leiterstruktur 42 entstehenden Streumagnetfeldes ausgebildet. Dies kann beispielsweise durch eine spiralförmige dritte Leiterstruktur 43 erzielt werden. So umschließt die dritte Leiterstruktur 43 einen dritten Mittelpunkt 53 in der dargestellten Ausführungsform spiralförmig. Der Abstand zwischen nebeneinander verlaufenden, insbesondere benachbarten, Abschnitten der dritten Leiterstruktur 43, insbesondere innerhalb einer von der dritten Leiterstruktur 43 gebildeten Spirale, ist vorzugsweise konstant und/oder unterliegt einer graduellen und/oder periodischen Änderung. Die dargestellte dritte Leiterstruktur 43 ist zumindest weitgehend dellenfrei. Die dargestellte dritte Leiterstruktur 43 kann als weitgehend gleichmäßige Verteilung eines Leiters in dem angegebenen räumlichen Bereich der Primärspule 32 angesehen werden. Ebenso ist die dritte Leiterstruktur 43 vorzugsweise zumindest weitgehend symmetrisch, insbesondere weitgehend punktsymmetrisch zu deren dritten Mittelpunkt 53. Eine Projektion des dritten Mittelpunktes 53 auf die Längsachse der Gradientenspuleneinheit 19 unterscheidet sich typischerweise von einer Projektion des ersten Mittelpunktes 51 und/oder des zweiten Mittelpunktes 52 auf die Längsachse der Gradientenspuleneinheit 19. Die dritte Leiterstruktur 43 ist in der dargestellten Ausführungsform dazu ausgebildet, eine gleichmäßige Stromdichte im räumlichen Bereich der dritten Leiterstruktur 43, insbesondere der Sekundärspule, zu erzeugen.

Bei einem Vergleich der in Figur 4 dargestellten ersten Leiterstruktur 41 und zweiten Leiterstruktur 42 mit der in Figur 5 dargestellten dritten Leiterstruktur 43 kann die dritte Leiterstruktur 43 als symmetrisch bezeichnet werden, wohingegen die erste Leiterstruktur 41 und die zweite Leiterstruktur 42 asymmetrisch ausgebildet sind.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Gradientenspuleneinheit umfassend eine Primärspule und eine Sekundärspule,
wobei die Primärspule eine erste Leiterstruktur und eine zweite Leiterstruktur umfasst,
die erste Leiterstruktur zu einer Erzeugung eines Magnetfeldgradienten in einem Patientenaufnahmebereich ausgebildet ist, die zweite Leiterstruktur zu einer Kompensation einer bei einer Erzeugung eines Magnetfeldgradienten entstehenden Kraft auf die Gradientenspuleneinheit ausgebildet ist,
und die Sekundärspule zu einer Kompensation eines bei Erzeugung eines Magnetfeldgradienten mittels Primärspule entstehenden Streumagnetfeldes ausgebildet ist.

2. Gradientenspuleneinheit nach Anspruch 1,
wobei die erste Leiterstruktur und die zweite Leiterstruktur jeweils zumindest teilweise spiralförmig ausgebildet sind.

3. Gradientenspuleneinheit nach einem der vorangehenden Ansprüche,
wobei die erste Leiterstruktur einen ersten Mittelpunkt und die zweite Leiterstruktur einen zweiten Mittelpunkt umschließen und der erste Mittelpunkt vom zweiten Mittelpunkt verschieden ist.

4. Gradientenspuleneinheit nach einem der vorangehenden Ansprüche,
wobei die erste Leiterstruktur und die zweite Leiterstruktur elektrisch miteinander verbunden sind.

5. Gradientenspuleneinheit nach einem der vorangehenden Ansprüche,
wobei die Sekundärspule eine dritte Leiterstruktur umfasst, welche zu einer Kompensation eines bei Erzeugung eines Magnetfeldgradienten mittels erster Leiterstruktur und zweiter Leiterstruktur entstehenden Streumagnetfeldes ausgebildet ist.

6. Gradientenspuleneinheit nach Anspruch 5,
wobei die dritte Leiterstruktur spiralförmig ausgebildet ist.

7. Gradientenspuleneinheit nach einem der Ansprüche 5 bis 6,
wobei die dritte Leiterstruktur dellenfrei ist.

8. Gradientenspuleneinheit nach einem der Ansprüche 5 bis 7,
wobei die dritte Leiterstruktur symmetrisch ist.

9. Gradientenspuleneinheit nach einem der Ansprüche 5 bis 8,
wobei die dritte Leiterstruktur dazu ausgebildet ist, eine gleichmäßige Stromdichte zu erzeugen.

10. Gradientenspuleneinheit nach einem der Ansprüche 5 bis 9,
wobei die erste Leiterstruktur, die zweite Leiterstruktur und die dritte Leiterstruktur innerhalb eines Quadranten der Gradientenspuleneinheit angeordnet sind.

11. Gradientenspuleneinheit nach einem der vorangehenden Ansprüche,
wobei die Gradientenspuleneinheit vier zueinander symmetrische Quadranten aufweist.

12. Gradientenspuleneinheit nach einem der vorangehenden Ansprüche,
wobei die Gradientenspuleneinheit hohlzylinderförmig ausgebildet ist und die zweite Leiterstruktur zwischen einem Längsende der Gradientenspuleneinheit und der ersten Leiterstruktur angeordnet ist.

13. Gradientenspuleneinheit nach einem der vorangehenden Ansprüche,
wobei die Sekundärspule einen größeren Radius aufweist als die Primärspule.

14. Magnetresonanzgerät umfassend eine Gradientenspuleneinheit nach einem der vorangehenden Ansprüche, eine Gradientensteuereinheit und einen Hauptmagneten.
